# EUROPEAN PATENT APPLICATION

(11) **EP 1 752 423 A2**
(43) Date of publication of application: **14.02.2007**
(21) Application number: 06121161.1
(22) Date of filing: 05.10.1999
(51) Int. Cl.: C03B 19/10, C03B 19/14, C03B 37/014, C23C 4/12, C23C 16/453, C23D 5/04

(54) **Method for spraying of glass particles**

(30) Priority: 05.10.1998 FI 982154
(62) Divisional of application: 99947495.0
(71) Applicant: Liekki Oy, 08500 Lohja (FI)
(72) Inventor: Rajala, Markku, 01280 Vantaa (FI); Eerola, Markus, 05470 Hyvinkää (FI); Tikkanen, Juha, 33700 Tampere (FI); Pitkänen, Ville, 05900 Hyvinkää (FI)
(74) Representative: Hakola, Unto Tapani

(57) **Abstract**

The invention relates to a method for spraying of a material, wherein at least two different components are introduced into a flame (9) formed by means of fuel gas in such a way that the components react with each other, forming multicomponent glass particles. By means of the flame (9), the multicomponent glass particles are sprayed to a desired target. The first component is introduced to the flame as a gas or a vapour, and the second component is introduced into the flame in liquid form and is atomized by means of gas substantially in the vicinity of the flame. The first and second components are supplied into the flame (9) with the same device as the fuel gas. The liquid component and the gaseous component are formed into particles having the size in the order of magnitude of a nanometre and their mutual reaction is effected in such a way that homogeneous multicomponent glass particles are formed.

## Description

The invention relates to a method for spraying of a material, in which method a flame is produced by means of fuel gas, at least two different components are introduced to the flame in such a way that the components combine with each other and form a material consisting of at least two components.

The invention is carried out by a device for spraying of a material, which device comprises means for supplying fuel gas in such a way that the fuel gas produces a flame, and means for introducing at least two different components to the flame in such a way that the components combine with each other and form a material consisting of at least two components, which can be sprayed to a desired target by means of the flame.

It is known to spray a solid substance with a flame spray device. In this method, the substance to be sprayed is fed to the flame spray gun in the form of solid particles which are sprayed by the flame spraying device to the desired target. When the particle size becomes smaller, the flame spray device is, however, easily soiled and clogged. Thus, it is difficult even to use the flame spray device to spray e.g. particles having a size of less than 20 micrometres, and the flame spray device is easily clogged and is expensive in its construction. Moreover, the solid matter to be sprayed is in several different phases during the flame spraying, being partly vapour, partly molten substance and substance molten in part, and when the substance is cooled, the final result is uneven.

US patent 3,883,336 presents a device in which silicon tetrachloride is supplied to a flame spray gun as a vapour by means of oxygen acting as a carrier gas. Further, said publication discloses that an aerosol is sprayed from outside to the flame of the flame spray gun to manufacture glass. However, the aerosol production requires a complex apparatus and, further, the aerosol formation requires that the viscosity of the liquid is within a certain range, which restricts the material combinations to be used. Moreover, the particles produced by the method are relatively large in size, *i.e.* in the order of magnitude of a micrometre.

Finnish patent 98832 presents a method and a device for spraying of a material, in which method the liquid substance to be sprayed is introduced to a flame formed with fuel gas and is atomized with a gas substantially in the vicinity of the flame so that the atomization and the flame formation take place in the same device. With said method, particles of the size of a nanometre can be produced in a simple and inexpensive way. However, the solution cannot be used to produce a material consisting of several components, *e.g.* multicomponent glass, with a controlled composition.

One application to produce multicomponent glass is the production of active fibres. In the production of active fibres, the glass material must be doped with rare earth metals, for example erbium. Erbium is not available as a liquid whose vapour pressure would be sufficiently low so that active fibres could be produced by conventional fibre production methods without extensive and expensive modification of the process. For this reason, the generally used method for producing active fibre is to manufacture a porous preform which substantially consists of amorphous silicon dioxide. The preform is immersed in a liquid containing erbium. After the impregnation of several hours, the preform is dried and sintered, thereby giving a doped fibre preform. The demerits of the method include indefiniteness of the doping quantity and clustering of the substance, which impairs the properties of the final product obtained. Furthermore, active fibre can be produced with an aerosol process, in which an erbium-containing aerosol is produced by an ultrasound method. The aerosols produced separately by the ultrasound method are led into a thermal reactor where they react to produce multicomponent glass. The drawbacks of this method are its complexity, difficulties in the doping, and the large size of the particles produced, that is, the particle size is in the order of magnitude of about one micrometre.

It is an aim of the present invention to provide a method whereby the above-mentioned drawbacks can be avoided.

The method according to the invention is characterized in that gas for atomizing the second component is introduced through the common nozzle, and the second component consisting of a rare earth metal containing liquid is atomized by the gas in the vicinity of the flame.

The device for carrying out the invention has a gas tube for introducing the first component to the flame in a gaseous or vaporous form, a liquid tube for introducing the second component to the flame in a liquid form, and a gas tube for introducing atomizing gas to the vicinity of the liquid tube for atomizing the liquid component substantially in the vicinity of the flame, wherein both the first component and the second component are arranged to be supplied to the flame with the same device as the fuel gas.

The essential idea of the invention is that at least two different components are led to the flame and that the first component is led to the flame as a gas or as a vapour, and the second component is led to the flame in liquid form and is atomized by means of gas substantially in the vicinity of the flame, and that the first and second component are fed to the flame together with the fuel gas with the same device. Thus, the liquid component and the gaseous component are formed into particles having a size in the order of magnitude of a nanometre, and their mutual reaction is accomplished in such a way that for example homogeneous multicomponent glass particles are formed. The produced particles can be further guided by means of the flame onto the surface of various materials, or they can be collected as separate particles with a suitable device, for example to produce active fibre.

The advantage of the invention is the capability to produce, in a very simple and inexpensive way, very fine and homogeneous particles consisting of at least two components, such as multicomponent glass particles.

The invention will be described in more detail in the appended drawing, in which
Fig. 1 shows schematically the entity of a flame spray device in a side view, and
Fig. 2 shows schematically a nozzle part of the device in a front view.

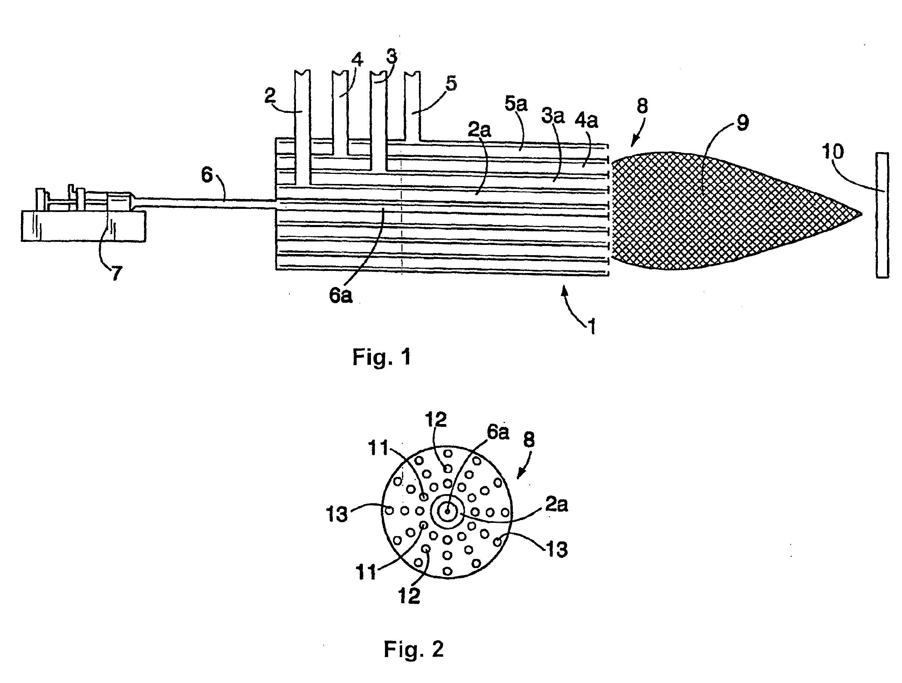

Figure 1 shows a flame spray device. A flame spray gun 1 is used to form a flame 9 to spray a material. The required gases are supplied to the flame spray gun 1 along gas ducts 2, 3, 4 and 5. Along the gas ducts 2―5 are supplied the fuel gases forming the flame, the atomizing gas for the liquid to be sprayed, one component, in gas or vapour form, of the material consisting of at least two components, such as multicomponent glass, and possibly a gas to be produced for controlling the reaction. The number of the gas ducts 2―5 is naturally sufficient according to the number of gases that need to be supplied to the flame spray gun 1. The second component of the multicomponent glass to be formed is supplied in liquid form to the flame spray gun 1, along a liquid duct 6. The liquid is transferred along the liquid duct 6 by pumping it for example with an injection pump 7. The transfer of the liquid along the liquid duct 6 can also be implemented for example by supplying the liquid from a pressure tank or in another way known as such.

At the right end of the flame spray gun 1, seen in Fig. 1, there is a nozzle 8 where the fuel gases are ignited to produce a flame and where the liquid is atomized by means of atomizing gas. The atomizing takes place substantially in the vicinity of the flame 9. Thus, the liquid component can be atomized into very fine particles, having a size in the order of magnitude of about one nanometre. Similarly, equally small particles can be formed of the gaseous or vaporous component. Both components are fed into the flame together with the fuel gas with the same device. Preferably, the feeding of the fuel gas, the feeding of the first component and the feeding of the second component into the flame is implemented with one and the same device, that is, via a common nozzle 8, as is shown in Fig. 1. It is thus very easy to direct the multicomponent glass particles to be sprayed to the target 10. The particles of the first and second component react with each other, forming homogeneous multicomponent glass particles. The multicomponent glass particles can be further directed by means of the flame 9 onto the surface of various materials, or they can be collected as separate particles using a suitable device.

The liquid component of the multicomponent glass is brought to the flame spray gun 1 along the liquid duct 6. From the liquid duct 6, the liquid is transferred to a liquid tube 6a in the centre of the flame spray gun 1. Along the first gas duct 2, the gas for atomizing the liquid is introduced into a first gas tube 2a surrounding the liquid tube. Along the second gas duct 3, a second gas is introduced into a second gas tube 3a surrounding the first gas tube 2a. Furthermore, along the third gas duct 4, a third gas is introduced into a third gas tube 4a surrounding the second gas tube 3a, and along the fourth gas duct 5, a fourth gas is introduced into a fourth gas tube 5a surrounding the third gas tube 4a. The liquid tube 6a and the first, second, third and fourth gas tubes 2a, 3a, 4a, and 5a are thus coaxial tubes within each other. The gas flowing from the first gas tube 2a in the nozzle 8 atomizes the liquid flowing along the liquid tube 6a into droplets.

The liquid component of the multicomponent glass to be formed can be a suitable aqueous or alcohol solution of the desired ion. For example in the production of active fibre, *i.e.* light intensifying fibre, it is possible to use a solution containing erbium nitrate, water or alcohol and a form of aluminium which is soluble in water or alcohol. Along the second gas duct 2 can be supplied for example hydrogen which atomizes the liquid in the nozzle 8. Along the second gas duct 3 can be supplied silicon or germanium tetrachloride in gaseous or vaporous form, and along the third gas duct 4 oxygen can be brought. After the nozzle 8, hydrogen and oxygen react to form a flame 9. The precise process of the reactive formation in the flame is unclear, but it can be assumed in practice that the silicon or germanium tetrachloride reacts by forming very small silicon dioxide or germanium dioxide particles, and the liquid particles react by forming erbium and aluminium oxide. The formed particles react either simultaneously or separately with the above-mentioned reactions and combine with each other to form homogeneous multicomponent glass. The produced multicomponent glass particles are guided by means of the flame 9 onto the surface of a target 10, which in the manufacture of an active fibre is a mandrel, whereby the multicomponent glass particles form a porous glass surface on the mandrel surface. On the mandrel surface it is possible to accumulate several different glass layers whose material composition can be altered in a simple manner, if necessary. After the accumulation, the mandrel can be removed, and the produced preform is sintered in a manner known as such from the manufacturing process of an optical fibre.

The fourth gas duct 5 and the respective fourth gas tube 5a are not necessary. However, they can be used when desired for improving the reaction control, for example by feeding e.g. argon or another suitable protective gas along the fourth gas duct 5 and further along the fourth gas tube 5a. The protective gas prevents the effect of external oxygen in the reaction.

It should be noted that in Fig. 1, the structure of the flame spray gun 1 is presented, for clarity, in a scale larger than the real situation. For effective atomization, it is preferable to make e.g. the velocity of the spraying gas as high as possible. Thus, the holes of the nozzle 8 should be made sufficiently small. Furthermore, the structure of the liquid tube 6a and the first gas tube 2a can be described so that said tubes are structurally two hollow needles placed one inside the other.

Figure 2 shows the nozzle 8 seen in a front view. Figure 2 shows the hole at the end of the liquid tube 6a coming along the centre of the nozzle 8. The hole of the first gas tube 2a can be seen around this hole. The gas flowing along the second gas tube 3a is shown to be introduced through the nozzle 8 via orifices 11. In a corresponding manner, the gas flowing along the third gas tube 4a is introduced through the nozzle 8 via orifices 12, and the gas flowing along the fourth gas tube 5a is led through the nozzle 8 via orifices 13. The size and geometry of the holes and orifices of the nozzle 8 may vary in a desired manner, but it is essential that the velocity of the liquid and the atomizing gas in the nozzle 8 can be adjusted as desired so that the liquid can be formed into sufficiently small droplets to allow sufficiently small particles to be produced and, on the other hand, to provide sufficient velocity of the gases forming the flame 9.

The drawing and the related description are only intended to illustrate the idea of the invention. In details, the invention may vary within the scope of the claims. Consequently, the location and order of the liquid tube and the gas tubes may vary in a desired way. Furthermore, the fuel gas can consist, in the above-described manner, of two or more gases to be supplied along separate gas tubes to the nozzle 8, or the fuel gas used can be a gas or gas mixture supplied along one gas tube to the nozzle 8, such as a mixture of oxygen and acetylene.

## Claims

**1.** A method for forming multicomponent glass particles and spraying the particles to a desired target comprising:
- producing a flame (9) using fuel gas,
- introducing oxygen to the flame,
- introducing a first component for forming multicomponent glass particles to the flame (9) in gaseous or vaporous form,
- introducing a second component for forming multicomponent glass particles, the second component consisting of a rare earth metal containing liquid,
- atomizing the second component, and
- introducing the atomized second component into the flame (9),
wherein the first component, the second component, the oxygen and the fuel gas are introduced to the flame (9) with a common nozzle (8), and wherein, after passing the common nozzle (8), the first and second components react with each other and the oxygen to form multicomponent glass particles, **characterized in that** gas for atomizing the second component is introduced through the common nozzle (8), and the second component consisting of a rare earth metal containing liquid is atomized by the gas in the vicinity of the flame.

**2.** The method according to claim 1, **characterized in that** the first component, the second component and the fuel gas are supplied to the flame (9) coaxially.

**3.** The method according to claim 1 or 2, **characterized in that** the second component consisting of a rare earth metal containing liquid is an aqueous or alcohol solution of a rare earth metal ion.

**4.** The method according to any preceding claim, **characterized in that** the first component is silicon or germanium tetrachloride and the second component is a solution containing erbium nitrate, water or alcohol, and aluminium compound which is soluble in water or alcohol, in such a way that multicomponent glass particles can be formed to manufacture active fibre.

**4.** The method according to any preceding claim, **characterized in that** the fuel gas comprises hydrogen by which the second component is atomized.

**5.** The method according to any preceding claim, **characterized in that** protective gas is supplied through the nozzle (8).
